# EUROPÄISCHE PATENTSCHRIFT

(11) **EP 2 620 411 B1**
(45) Veröffentlichungstag und Bekanntmachung des Hinweises auf die Patenterteilung: **17.09.2014**
(21) Anmeldenummer: 13151460.6
(22) Anmeldetag: 16.01.2013
(51) Int. Cl.: C01B 33/02, C01B 33/021, C01B 33/035

(54) **Dotierstoffarmes polykristallines Siliciumstück**
Low-dopant polycrystalline silicon chunk
Pièce de silicium polycristallin pauvre en dopant

(30) Priorität: 24.01.2012 DE 102012200992
(43) Veröffentlichungstag der Anmeldung: 31.07.2013
(73) Patentinhaber: Wacker Chemie AG, 81737 München (DE)
(72) Erfinder: Wochner, Hanns Dr., 84489 Burghausen (DE); Killinger, Andreas Dr., 81539 München (DE); Pech, Reiner Dr., 84524 Neuötting (DE)
(74) Vertreter: Killinger, Andreas

(56) Entgegenhaltungen:
- EP-A1- 2 431 329
- EP-A2- 0 345 618
- DE-A1-102011 077 455

## Beschreibung

Gegenstand der Erfindung ist ein dotierstoffarmes polykristallines Siliciumbruchstück.

Im industriellen Maßstab wird Rohsilicium durch die Reduktion von Siliciumdioxid mit Kohlenstoff im Lichtbogenofen bei Temperaturen von etwa 2000 °C gewonnen.

Dabei erhält man sog. metallurgisches Silicium (Si_{mg}, "metallurgical grade") mit einer Reinheit von etwa 98-99 %.

Für Anwendungen in der Photovoltaik und in der Mikroelektronik muss das metallurgische Silicium gereinigt werden.
Dazu wird es beispielsweise mit gasförmigem Chlorwasserstoff bei 300-350 °C in einem Wirbelschichtreaktor zu einem Silicium enthaltenden Gas, beispielsweise Trichlorsilan, umgesetzt. Darauf folgen Destillationsschritte, um das Silicium enthaltende Gas zu reinigen.

Dieses hochreines Silicium enthaltende Gas dient dann als Ausgangsstoff für die Herstellung von hochreinem polykristallinem Silicium.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") dünne Filamentstäbe aus Silicium durch direkten Stromdurchgang erhitzt und ein Reaktionsgas enthaltend eine Silicium enthaltende Komponente und Wasserstoff wird eingeleitet.

Die Silicium enthaltende Komponente des Reaktionsgases ist in der Regel Monosilan oder ein Halogensilan der allgemeinen Zusammensetzung SiHₙX₄₋ₙ (n=0, 1, 2, 3; X = Cl, Br, I). Bevorzugt handelt es sich um ein Chlorsilan, besonders bevorzugt um Trichlorsilan. Überwiegend wird SiH₄ oder SiHCl₃ (Trichlorsilan, TCS) im Gemisch mit Wasserstoff eingesetzt.

Beim Siemens-Prozess stecken die Filamentstäbe üblicherweise senkrecht in am Reaktorboden befindlichen Elektroden, über die der Anschluss an die Stromversorgung erfolgt. Je zwei Filamentstäbe sind über eine waagrechte Brücke (ebenfalls aus Silicium) gekoppelt und bilden einen Trägerkörper für die Siliciumabscheidung. Durch die Brückenkopplung wird die typische U-Form der auch Dünnstäbe genannten Trägerkörper erzeugt.

An den erhitzten Stäben und der Brücke scheidet sich hochreines Polysilicium ab, wodurch der Stabdurchmesser mit der Zeit anwächst (CVD / Gasphasenabscheidung).

Nach Beendigung der Abscheidung werden diese Polysiliciumstäbe üblicherweise mittels mechanischer Bearbeitung zu Bruchstücken unterschiedlicher Größenklassen weiterverarbeitet, klassifiziert, gegebenenfalls einer nasschemischen Reinigung unterzogen und schließlich verpackt.

Polykristallines Silicium dient als Ausgangsmaterial bei der Herstellung von einkristallinem Silicium mittels Tiegelziehen (Czochralski- oder CZ-Verfahren)- oder mittels Zonenschmelzen (Floatzone oder FZ-Verfahren).

Insbesondere wird aber polykristallines Silicium zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Da die Qualitätsanforderungen an Polysilicium immer höher werden, sind ständige Prozessverbesserungen hinsichtlich Kontaminationen mit Metallen oder Dotierstoffen notwendig. Zu unterscheiden ist die Kontamination im Bulk und die Kontamination an der Oberfläche der Polysiliciumbruchstücke oder -stabstücke.

US2003/0159647 A1 offenbart polykristalline Siliciumbruchstücke mit Verunreinigungen von kleiner oder gleich 0,06 ppba Bor und von kleiner oder gleich 0,02 ppba Phosphor im Bulk. Über die Kontamination der Oberfläche mit Dotierstoffen gibt US2003/0159647 A1 keine Auskunft.

EP1544167 A1 offenbart polykristallines Siliciumgranulat, wobei die Partikel eine Teilchengröße zwischen 100 µm und 3000 µm, einen Dotierstoffgehalt an Phosphor kleiner als 300 ppta, einen Dotierstoffgehalt an Bor kleiner als 300 ppta und einen Gesamtgehalt an den Metallen Fe, Cr, Ni, Cu, Ti, Zn, und Na von weniger als 50 ppbw aufweisen. Über die Kontamination der Oberfläche des Granulats mit Dotierstoffen gibt EP1544167 A1 keine Auskunft.

In beiden genannten Veröffentlichungen werden nur Dotierstoffkonzentrationen im Bulk (US2003/0159647 A1) oder Gesamtkonzentrationen (Bulk und Oberfläche, EP1544167 A1) genannt.

Es ist bekannt, dass die Prozessschritte zur Erzeugung von Polysilicium wie das Zerkleinern von Stäben eine Einfluss auf die Oberflächenverunreinigungen mit Metallen und Dotierstoffen haben.

DE 41 37 521 A1 beschreibt ein Verfahren zur Analyse der Konzentration an Verunreinigungen in Siliciumteilchen, dadurch gekennzeichnet, dass teilchenförmiges Silicium in ein Siliciumgefäß gegeben, das teilchenförmige Silicium und das Siliciumgefäß zu monokristallinem Silicium in einer Schwebezone aufarbeitet und die Konzentration an Verunreinigungen, die in dem monokristallinen Silicium vorhanden sind, bestimmt werden. Die Konzentrationen an Bor, Phosphor, Aluminium und Kohlenstoff im verwendeten Siliciumgefäß wurden bestimmt und liefern einen reproduzierbaren Hintergrundwert.

Die nach dem Schwebezonenverfahren mittels FTIR (Fourier-Transform IR-Spektroskopie) ermittelten Werte an Bor, Phosphor und Kohlenstoff wurden korrigiert um den Anteil, der aus dem Siliciumgefäß stammte.

In dieser Anmeldung wird auch gezeigt, dass die Fragmentierung eines polykristallinen Siliciumstabes zu einer Kontamination des Siliciums führt. Dies ist möglich, indem Siliciumfragmente in das Siliciumgefäß gegeben, dem Schwebezonenverfahren unterzogen und anschließend auf Verunreinigungen untersucht werden. Da die Kontamination des Grundmaterials vor Fragmentierung bekannt ist, kann auf die zusätzliche Kontamination durch die Fragmentierung geschlossen werden.

DE 43 30 598 A1 offenbart ebenfalls ein Verfahren, das es ermöglicht, auf die Verunreinigung von Silicium infolge von Zerkleinerungsprozessen zu schließen. Ein Siliciumblock wurde in Brocken zerbrochen. Der Siliciumbrocken wurde anschließend einem Zonenschmelzverfahren unterzogen und in einen Einkristall überführt. Vom Einkristall wurde ein Wafer herausgesägt und mittels Photolumineszenz auf Bor und Phosphor untersucht. Gegenüber dem durchschnittlichen Bor- und Phosphorgehalt des verwendeten Siliciumblocks zeigt sich eine Erhöhung der Bor- und Phosphor-Konzentration, die u.a. auch auf den Zerkleinerungsprozess zurückzuführen ist.

Dotierstoffe werden nach SEMI MF 1398 an einem aus dem polykristallinen Material erzeugten FZ-Einkristall (SEMI MF 1723) mittels Photolumineszenz analysiert. Alternativ kommt Niedrigtemperatur-FTIR zum Einsatz (SEMI MF 1630).

Grundlagen des FZ-Verfahrens sind beispielsweise in der DE-3007377 A beschrieben.

Beim FZ-Verfahren wird ein polykristalliner Vorratsstab mit Hilfe einer Hochfrequenzspule nach und nach aufgeschmolzen und das schmelzflüssige Material durch Animpfen mit einem einkristallinen Impflingskristall und anschließendem Rekristallisieren in einen Einkristall überführt. Bei der Rekristallisation wird der Durchmesser des entstehenden Einkristalls zunächst kegelförmig vergrößert (Konusbildung) bis ein gewünschter Enddurchmesser erreicht ist (Stabbildung). In der Phase der Konusbildung kann der Einkristall auch mechanisch gestützt werden, um den dünnen Impflingskristall zu entlasten.

Im Stand der Technik wurden zwar Anstrengungen unternommen, den Einfluss eines einzelnen Prozessschrittes auf etwaige Oberflächenkontamination von Polysilicium mit Dotierstoffen zu untersuchen.

Bislang ist es jedoch nicht gelungen, die Dotierstoffe an der Oberfläche von Polysilicium deutlich zu reduzieren, obwohl bekannt ist, dass Dotierstoffe die physikalischen Eigenschaften des Materials beeinflussen.

Aus der beschriebenen Problematik ergab sich die Aufgabenstellung der Erfindung.

Die Aufgabe der Erfindung wird gelöst durch ein polykristallines Siliciumbruchstück mit einer Konzentration von 1-50 ppta Bor und 1-50 ppta Phosphor an der Oberfläche.

Vorzugsweise beträgt die Konzentration von Bor an der Oberfläche 1-30 ppta, besonders bevorzugt 1-20 ppta.

Vorzugsweise beträgt die Konzentration von Phosphor an der Oberfläche 1-25 ppta, besonders bevorzugt 1-20 ppta.

Vorzugsweise beträgt die Oberflächenverunreinigung mit Arsen 0,01-10 ppta, besonders bevorzugt 0,01-5 ppta, ganz besonders bevorzugt 0,01-2 ppta.

Vorzugsweise beträgt die Oberflächenverunreinigung mit Aluminium 0,01-10 ppta, besonders bevorzugt 0,01-5 ppta, ganz besonders bevorzugt 0,01-2 ppta.

Die Dotierstoff-Oberflächenverunreinigungen von polykristallinem Silicium lassen sich bestimmen, indem von zwei durch Abscheidung in einem Siemensreaktor erzeugten polykristallinen Siliciumstäben der eine Stab unmittelbar nach der Abscheidung hinsichtlich Verunreinigungen mit Dotierstoffen (Bulk und Oberfläche) untersucht wird, während der zweite Stab die Anlagen, in denen der Stab weiterverarbeitet wird, durchläuft und nach Durchlaufen der Anlagen ebenfalls hinsichtlich Verunreinigungen mit Dotierstoffen (Bulk und Oberfläche) untersucht wird. Da beiden Stäben das gleiche Niveau an Bulk-Verunreinigungen zugeordnet werden kann, ergibt sich durch Differenz der beiden ermittelten Verunreinigungen die Oberflächenverunreinigung, die durch die Weiterverarbeitungsschritte wie Zerkleinern, Reinigen, Transportieren und Verpacken verursacht wird. Dies kann zumindest dann sichergestellt werden, wenn Stab und Bruderstab auf ein- und demselben U-förmigen Trägerkörper abgeschieden wurden.

Alternativ kann das in DE 41 37 521 A1 beschriebene Verfahren verwendet werden. Dazu werden kleine Bruchstücke, die aus einem polykristallinen Siliciumstab erzeugt wurden, in ein Siliciumgefäß eingebracht und mit dem Siliciumgefäß zu einem Einkristall verarbeitet. Hier müssen allerdings von den ermittelten Gesamtverunreinigungen die Konzentrationen im Bulk und die Kontamination des Siliciumgefäßes abgezogen werden.

Dotierstoffe (B, P, As, A1) werden im Rahmen der Erfindung nach SEMI MF 1398 an einem aus dem polykristallinen Material erzeugten FZ-Einkristall (SEMI MF 1723) mittels Photolumineszenz analysiert.

Von dem aus einem polykristallinen Siliciumstab oder aus polykristallinen Siliciumbruchstücken mittels FZ erzeugten einkristallnen Stab wird eine Scheibe (Wafer) abgetrennt, mit HF/HNO3-geätzt, mit 18 MOHm Wasser gespült und getrocknet. An dieser Scheibe werden die Photolumineszenzmessungen durchgeführt.

Vorzugsweise betragen die Konzentrationen an Dotierstoffen im Bulk:
- Phosphor 1-20 ppta, besonders bevorzugt 1-10 ppta;
- Bor 1-10 ppta, besonders bevorzugt 1-5 ppta
- Arsen 1-10 ppta, besonders bevorzugt 1-5 ppta.

Diese Werte werden durch die Reinheit des Reaktionsgases bei der Abscheidung bestimmt. Wie die benötigte Reinheit des Reaktionsgases bewerkstelligt wird, wird später erläutert.

Vorzugsweise weist das polykristalline Siliciumbruchstück zudem eine geätzte Oberfläche auf.

Vorzugsweise weist das polykristalline Siliciumbruchstück eine Konzentration an Metallen an der Oberfläche von weniger als 200 pptw (10-200 pptw), besonders bevorzugt 10-100 pptw auf.

Die Metalle umfassen Na, K, Ca, Mg, Ti, Cr, Fe, Co, Ni, Cu, Zn, Ga, Br, Sr, Zr, Mo, Cd, In, Sn, Ba und Pt.

Vorzugsweise beträgt die Oberflächenverunreinigung mit Fe 1-40 pptw, mit Cr 0,1-5 pptw, mit Cu 0,1-5 pptw, mit Na 1-30 pptw, mit Ni 0,1-5 pptw, mit Zn 0,1-10 pptw, mit Ti 0,1-10 pptw und mit W 0,1-10 pptw.

Vorzugweise beträgt die Oberflächenverunreinigung mit Ca 0,1-10 pptw, besonders bevorzugt 0,1-5 pptw, ganz besonders bevorzugt 0,1-1 pptw.

Die Oberflächenverunreinigung mit Fe beträgt vorzugweise 1-20 pptw.

Die Bestimmung der Oberflächenmetalle erfolgt im Rahmen der Erfindung nach ASTM F 1724-96 durch chemisches Ablösen der Silicium-Oberfläche und anschließender Analyse der abgelösten Lösung mittels ICPMS (inductively-coupled-plasma massspectrometry) bestimmt.

Die für das polykristalline Siliciumbruchstück angegebenen Werte für Oberflächendotierstoffe und -metalle gelten unabhängig von der Bruchgröße, die als längste Entfernung zweier Punkte auf der Oberfläche eines Silicium-Bruchstücks (=max. Länge) wie folgt definiert ist:
- Bruchgröße 0 in mm: ca. 0.5 bis 5
- Bruchgröße 1 in mm: ca. 3 bis 15
- Bruchgröße 2 in mm: ca. 10 bis 40
- Bruchgröße 3 in mm: ca. 20 bis 60
- Bruchgröße 4 in mm: ca. > 45

Die zuvor genannten Werte für die Konzentration von Metallen können nur durch eine Reinigung der polykristallinen Siliciumbruchstücke wie nachfolgend in c) Reinigung der polykristallinen Siliciumbruchstücke beschrieben, erreicht werden.

### Herstellung des erfindungsgemäßen polykristallinen Siliciumbruchstücks

### a) Abscheidung von polykristallinem Silicium in einem Siemens-Reaktor

Polykristallines Silicium wird an erhitzten Silicium-Dünnstäben abgeschieden, wobei als Reaktionsgas eine Silicium enthaltende Komponente und Wasserstoff verwendet werden. Vorzugsweise handelt es sich bei der Silicium enthaltenden Komponente um ein Chlorsilan, besonders bevorzugt um Trichlorsilan.

Die Abscheidung erfolgt gemäß Stand der Technik, wobei z.B. auf WO 2009/047107 A2 verwiesen wird.

Um die Verunreinigungen der Silicium enthaltenden Komponente des Reaktionsgases mit Dotierstoffen wie Bor und Phosphor zu reduzieren, sind verschiedene Verfahren bekannt.

DE 10 2007 014 107 A1 beschreibt ein destillatives Verfahren. In EP 2 036 858 A2 wird ein Verfahren beansprucht, in dem Bor- und Phosphor-haltige Chlorsilane mit dem Komplexbildner Benzaldehyd und Sauerstoff in Kontakt gebracht werden.
Gemäß DE 10 2008 054 537 wird der Bor-Gehalt in Chlorsilanen durch Inkontaktbringen mit wasserfreien Adsorbermittel abgesenkt.

Diesbezüglich wird auch auf die nichtvorveröffentlichte deutsche Anmeldung mit dem Akzenzeichen 102011003453.6 verwiesen, auf die hier in vollem Umfang Bezug genommen wird. Dabei werden niedrig-siedende Borverbindungen mittels Kopfströmen enthaltend borangereichertes DCS (Dichlorsilan) und höher-siedende Borverbindungen mittels eines borangereicherten Sumpfstromes enthaltend Hochsieder aus den Destillationskolonnen abgezweigt. Das Verfahren ist geeignet, den Bor- und den Phosphorgehalt auf Größenordnung ppb zu reduzieren.

Daher ist es besonders bevorzugt, Chlorsilane erst nach einem solchen Destillationsschritt für die Abscheidung von polykristallinem Silicium zu verwenden. Nur so sind die zuvor genannten Bulkwerte P 1-20 ppta, B 1-10 ppta und As 1-10 ppta zu bewerkstelligen. Hierbei ist anzumerken, dass nicht die gesamten im Reaktionsgas enthaltenen Dotierstoffe in das Polysilicium eingebaut werden. Ein Teil der Dotierstoffe wird über Abgase aus dem Abscheidereaktor abgeführt.

### b) Zerkleinern des polykristallinen Siliciums

Nach der Abscheidung im Siemensreaktor werden die Siliciumstäbe aus dem Reaktor entnommen.

Bevor man dieses Polysilicium in Kristallisationsverfahren verwenden kann, muss man es zerkleinern. Im Herstellungsprozess von Reinstsilicium ist es an verschiedenen Prozessschritten notwendig, Siliciumstäbe verschiedener Querschnitte und Längen zu brechen, um diese als Stabstücke oder Bruchstücke (Chips, chunks) unmittelbar oder nach sich daran anschließenden Mahlprozessen in andere Herstellungsschritte als Ausgangsmaterial einzubringen.

Zur Erzeugung des erfindungsgemäßen Siliciumbruchstücks erfolgt zunächst eine Vorzerkleinerung des Polysiliciumstabs. Dazu wird ein Hammer aus einem abriebsarmen Werkstoff, z.B. Hartmetall verwendet. Ein Hammerstiel besteht aus Kunststoff, der weniger als 10 ppbw an B, P und As enthält. Der dabei verwendete Kunststoff wird ausgewählt aus einem oder mehreren Elementen der Gruppe bestehend aus Polypropylen, Polyethylen, PU und Polyvinylidenfluorid (PVDF).

Das Vorzerkleinern erfolgt auf einem Arbeitstisch mit einer Oberfläche, die vorzugsweise aus verschleißarmem Kunststoff oder aus Silicium besteht.
Der verwendete Kunststoff enthält weniger als 10 ppbw an B, P und As. Er wird ausgewählt aus einem oder mehreren Elementen der Gruppe bestehend aus Polypropylen, Polyethylen, PU und Polyvinylidenfluorid (PVDF).

Das Silicium sollte bzgl. der Konzentrationen an Dotierstoffen folgenden Bedingungen genügen: Phosphor 1-20 ppta, Bor 1-10 ppta, Arsen 1-10 ppta.

Anschließend erfolgt eine Zerkleinerung des vorzerkleinerten Polysiliciums auf die gewünschte Zielgröße Bruchgröße 0, 1, 2, 3 oder 4.

Die Zerkleinerung erfolgt mittels eines Brechers, z.B. mit einem Backenbrecher.

Ein solcher Brecher ist beispielsweise beschrieben in EP 338 682 A2.

Anschließend wird das gebrochene Silicium mittels eines mechanischen Siebs in Bruchgrößen klassifiziert, wobei das mechanische Sieb mit Kunststoff oder mit Silicium ausgekleidet ist. Der verwendete Kunststoff enthält weniger als 10 ppbw an B, P und As. Der dabei verwendete Kunststoff wird ausgewählt aus einem oder mehreren Elementen der Gruppe bestehend aus Polypropylen, Polyethylen, PU und Polyvinylidenfluorid (PVDF).

Das Silicium sollte bzgl. der Konzentrationen an Dotierstoffen folgenden Bedingungen genügen: Phosphor 1-20 ppta, Bor 1-10 ppta, Arsen 1-10 ppta.

Beide Anlagen, sowohl Arbeitstisch und Hammer zur Vorzerkleinerung, als auch Brecher befinden sich in einem Reinraum der Klasse kleiner oder gleich 10000.

Vorzugsweise befinden sich die Anlagen in einem Reinraum der Klasse 100 oder besser(nach US FED STD 209E, abgelöst durch ISO 14644-1).

Bei Klasse 100 (ISO 5) dürfen max. 3,5 Partikel von max. 0,5 µm Durchmesser pro Liter enthalten sein.

Im Reinraum werden ausschließlich Reinraumfilter mit einer PTFE-Membran verwendet. Es ist sicherzustellen, dass die Filter frei von Bor sind.

Der Reinraumfilter sollte wie folgt aufgebaut sein:
Er umfasst einen nicht-verziehbaren Rahmen, der wenig Partikel abgibt, vorzugsweise aus Holz, z.B. Sperrholz, oder aus Aluminium.

Der Filter umfasst weiterhin ein Stützgewebe, das aus drei Schichten besteht. Eine obere und eine untere Schicht bestehen aus PE + PET. Bei der mittleren Schicht handelt es sich um PTFE.

Wichtig ist, dass der Bor-Gehalt im PTFE der mittleren Schicht des Stützgewebes weniger als 10 mg/kg beträgt.
Stützgewebe ist mit dem Rahmen verklebt.
Der Bor-Gehalt in Kleber, bei dem es sich vorzugsweise um Polyvinylacetat handelt, muss kleiner als 10 mg/kg, betragen.

Der Phosphor-Gehalt im Kleber muss kleiner als 50 mg/kg betragen.

Der Antimongehalt im Kleber beträgt vorzugsweise ebenfalls kleiner als 10 mg/kg.

Der Bor- und der Phosphor-Gehalt im Stützgewebe müssen weniger als 10 mg/kg betragen.

Der Antimongehalt im Stützgewebe (Drei Schichten PE + PET & PTFE) beträgt vorzugsweise weniger als 50 mg/kg.

Vorzugsweise ist im Reinraum ein Ionisationssystem implementiert, um durch aktive Luftionisation elektrostatische Ladungen zu neutralisieren. Ionisatoren durchsetzen die Reinraumluft derart mit Ionen, dass statische Ladungen an Isolatoren und ungeerdeten Leitern abgebaut werden.

Zum Auskleiden von Metallteilen am Brecher wird wenigstens ein Kunststoff, ausgewählt aus einem oder mehreren Elementen der Gruppe bestehend aus Polypropylen, Polyethylen, PU und PVDF, verwendet, wobei die Auskleidung des Brechers weniger als 100 ppbw Bor, weniger als 100 ppbw Phosphor und weniger als 10 ppbw Arsen enthält.

### c) Reinigung der polykristallinen Siliciumbruchstücke

Optional werden die Bruchstücke gereinigt.

Dazu werden die Polysiliciumbruchstücke in einer Vorreinigung in zumindest einer Stufe mit einer oxidierenden Reinigungslösung gewaschen, in einer Hauptreinigung in einer weiteren Stufe mit einer Reinigungslösung gewaschen, die Salpetersäure und Fluorwasserstoffsäure enthält, und bei einer Hydrophilierung in noch einer weiteren Stufe mit einer oxidierenden Reinigungsflüssigkeit gewaschen.

Vorreinigung erfolgt vorzugsweise mittels HF/HCl/H₂O₂. Hydrophilierung der Siliciumoberfläche erfolgt vorzugsweise mittels HCl/H₂O₂.

Die Reinigungsanlage befindet sich in einem Reinraum der Klasse kleiner oder gleich 10000, vorzugsweise in einem Reinraum der Klasse 100 oder besser.

Im Reinraum werden ausschließlich Reinraumfilter mit einer PTFE-Membran verwendet, mit einem Aufbau und einer Zusammensetzung wie unter b) Zerkleinern des polykristallinen Siliciums beschrieben.

Zum Auskleiden von Ätzbecken und Rohrleitungen muss wenigstens ein Kunststoff, ausgewählt aus einem oder mehreren Elementen der Gruppe bestehend aus Polypropylen, Polyethylen, PU und PVDF, verwendet werden, der weniger als 100 ppbw Bor, zudem weniger als 100 ppbw Phosphor und vorzugsweise auch weniger als 10 ppbw Arsen enthält.

Bei den im Reinigungsverfahren verwendeten Säuren wie z.B. HF, HCl und HNO₃ ist darauf zu achten, dass diese weniger als 10 ppbw Bor und zudem weniger als 500 ppbw Phosphor enthalten.

Vorzugsweise enthalten die Säuren weniger als 50 ppbw Arsen.

Um die Verwendung dotierstoffarmer Säuren sicherzustellen, werden die Dotierstoffgehalte der Säuren von Vor- und Hauptreinigung und Hydrophilierung diesbezüglich überwacht. Dazu wird vor jedem der Reinigungsvorgänge der Bor-, Phosphor- und Arsen-Gehalt überprüft. Falls die o.g. Werte überschritten werden, werden die Säuren ausgetauscht oder frische Säure in die Reinigungsbecken zudosiert, um sicherzustellen, dass weniger als 10 ppbw Bor und weniger als 500 ppbw Phosphor in den Säuren enthalten sind.

Nach dem Reinigen wird das Polysilicium getrocknet, wobei ein Luftstrom mit Temperatur von 20 bis 120°C durch einen Filter mit einer PTFE-Membran geführt wird, und dann auf eine Prozessschale enthaltend Polysilicium gerichtet wird, um dieses zu trocknen.

Vorzugsweise handelt es sich beim Filter um einen Reinstfilter der Reinraumklasse 100 oder besser. Dieser hat vorzugsweise einen Aufbau und eine Zusammensetzung wie unter b) Zerkleinern des polykristallinen Siliciums beschrieben.

Der Filter darf unter keinen Umständen aus Glasfaser bestehen, zumal diese mehr als 10 Gew.-% Bor enthalten können.

Vorzugsweise umfasst die Vorrichtung einen Vorfilter aus Kunststoffmatten ohne Glasfaseranteil.

### d) Verpacken der polykristallinen Siliciumbruchstücke

Nach der Reinigung bzw. direkt nach dem Zerkleinern (falls keine Reinigung erfolgt) werden die Polysiliciumbruchstücke verpackt.

Dazu werden Handschuhe aus hochreinem Polyethylen oder aus PU verwendet.

Das Material, aus dem die Handschuhe bestehen, muss weniger als 100 ppbw Bor, weniger als 100 ppbw Phosphor und weniger als 10 ppbw Arsen enthalten.

Solche Handschuhe werden idealerweise bei allen manuellen Handlingsschritten, die im Rahmen der Herstellung des erfindungsgemäßen Siliciumbruchstücks notwendig sind, benutzt.

Die Verwendung von glasfaserverstärkten Materialien bei den Handschuhen ist zu vermeiden.

Die Polysiliciumbruchstücke werden in PE-Beutel, vorzugsweise in PE-Doppelbeutel verpackt.

### Beispiele

### Beispiel 1 - Erzeugung eines dotierstoffarmen ungereinigten Polybruchs

Auf einem Arbeitstisch mit seitlichen Oberflächen aus Kunststoff(B, P, As-Gehalt < 10 ppbw) wurde ein polykristalliner Siliciumstab mittels eines Hammers aus Hartmetall mit einem Stiel aus Kunststoff (B, P, As < 10 ppbw) zerkleinert.

Die Oberfläche der Arbeitsplatte des Arbeitstisches bestand aus Silicium. Das Silicium weist bzgl. der Konzentrationen von Dotierstoffen folgende Werte auf: Phosphor max. 10 ppta, Bor max. 5 ppta, Arsen max. 5 ppta.

Der Arbeitstisch befand sich in einem Reinraum der Klasse 10000 mit Reinraumfiltern mit PTFE-Membran, vorzugsweise mit Filtern wie unter b) Zerkleinern des polykristallinen Siliciums beschrieben.

Manuelles Handling des Stabs erfolgte mittels Handschuhen aus hochreinen PE mit weniger als 100 ppbw Bor, weniger als 100 ppbw Phosphor und weniger als 10 ppbw Arsen.

An der Seite des Arbeitstisches wurde ein 10 bis 20 cm langer polykristalliner Stab mit einem Durchmesser von 1,6 cm für 10 Minuten ausgelegt. Diese Zeit entspricht der mittleren Verweildauer des Materials auf dem Arbeitstisch, bis es in den PE-Beutel verpackt wird.

Nach 10 Minuten wurde dieser polykristalline Stab verpackt und anschließend auf Verunreinigungen mit Dotierstoffen analysiert.

Dies wurde für 12 polykristalline Siliciumstäbe #1-#12 durchgeführt.

12 weitere polykristalline Siliciumstäbe #13-#24 wurden zudem durch den Brecher geführt, ohne sie zu zerkleinern, wodurch sie jedoch der Umgebung des Brechers ausgesetzt waren.

Der Brecher befand sich in einem Reinraum der Klasse 10000.

Im Reinraum wurden ausschließlich Reinraumfilter mit einer PTFE-Membran verwendet (Borfreie PTFE-Filter), wie unter b) Zerkleinern des polykristallinen Siliciums beschrieben.

Zum Auskleiden von Metallteilen am Brecher wurden Polypropylen und Polyethylen, enthaltend höchstens ca. 90 ppbw Bor, höchstens ca. 90 ppbw Phosphor, höchstens ca. 8 ppbw Arsen verwendet.

Nach Durchlaufen des Brechers wurden diese polykristallinen Stäbe #13-#24 verpackt und anschließend auf Verunreinigungen mit Dotierstoffen analysiert.

Jeder der 24 untersuchten polykristallinen Stäbe hat einen Bruderstab, der gleichzeitig unter denselben Bedingungen auf einem U-förmigen Trägerkörper in einem Siemens-Reaktor abgeschieden wurde. Nach der Abscheidung wurde der U-förmige Trägerkörper aus dem Reaktor entnommen, die Brücke abgetrennt, so dass jeweils ein Stab und ein Bruderstab erhalten wurden. Der Bruderstab wurde unmittelbar nach der Abscheidung in einen PE-Beutel verpackt und auf Verunreinigungen mit Dotierstoffen untersucht.

Da beide Stäbe, Stab und Bruderstab, unter denselben Bedingungen auf demselben U-förmigen Trägerkörper abgeschieden wurden, wiesen sie nach Abscheidung das gleiche Niveau an Verunreinigungen auf.

Der polykristalline Stab, der während des Zerkleinerns auf dem Arbeitstisch abgelegt war bzw. durch den Brecher geführt wurde, war jedoch anschließend der Umgebung der Zerkleinerungsvorgänge ausgesetzt und wurde dadurch gegebenenfalls kontaminiert.

Es konnte gezeigt werden, dass die zusätzliche Kontamination durch die Maßnahmen wie Arbeiten im Reinraum mit speziellen Reinraumfiltern, Verkleidung von Stahlteilen des Zerkleinerungswerkzeugs mit Kunststoff sowie durch Handling mit hochreinen PE-Handschuhen auf ein äußerst niedriges Niveau beschränkt werden konnte.

**Tabelle 1** zeigt die für **Beispiel 1** bestimmten Oberflächenverunreinigungen mit Bor, Phosphor, Aluminium und Arsen am Siliciumstab.

Diese wurden für jeden der 24 Stäbe ermittelt durch Bildung der Differenz der Verunreinigungen des am Arbeitstisch abgelegten bzw. zusätzlich durch den Brecher geführten Stabs und der Verunreinigungen des dazugehörigen Bruderstabs.

Diese Ergebnisse konnten auch am mittels des Hammers vorzerkleinerten polykristallinen Stab mit der alternativen Messmethode des Hülsenziehens reproduziert werden.

Dazu wurden die mittels des Hammers vorzerkleinerten Siliciumbruchstücke auf Bruchgröße 0 und 1 weiter zerkleinert.

**Tabelle 1**

| | **B in ppta** | **P in ppta** | **Al in ppta** | **As in ppta** |
|---|---|---|---|---|
| #1 | 11 | 43 | 0,7 | 0,3 |
| #2 | 4 | 46 | 0, 6 | 0,9 |
| #3 | 9 | 21 | 0,4 | 0, 6 |
| #4 | 18 | 27 | 0,3 | 1,3 |
| #5 | 11 | 16 | 0, 6 | 2 |
| #6 | 15 | 4 | < 0,6 | 2 |
| #7 | 11 | 5 | < 0,1 | < 0,1 |
| #8 | 12 | 24 | < 0,1 | 1 |
| #9 | 2 | 11 | 8 | < 0,1 |
| #10 | 18 | 2 | <0,1 | 2 |
| #11 | 47 | 13 | < 0,11 | 2 |
| #12 | 28 | 3 | < 0,11 | 6 |
| #13 | 33 | 15 | 1 | 2 |
| #14 | 26 | 5 | < 0,1 | 1 |
| #15 | 17 | 21 | < 0,1 | 1 |
| #16 | 20 | 17 | < 0,1 | 2 |
| #17 | 29 | < 1 | < 0,1 | < 0,1 |
| #18 | 21 | 5 | < 0,1 | < 0,1 |
| #19 | 31 | 6 | 5 | 8 |
| #20 | 38 | 2 | 0,3 | 3 |
| #21 | 29 | 17 | 1 | 5 |
| #22 | 39 | 44 | < 0,1 | 8 |
| #23 | 4 | 11 | < 0,1 | 7 |
| #24 | 24 | 26 | 2 | 2 |

Die Zerkleinerung erfolgt wiederum mittels eines Brechers wie zuvor beschrieben, der sich in einem Reinraum der Klasse 10000 befand. Zum Auskleiden von Metallteilen am Brecher wurden Polypropylen und Polyethylen, enthaltend höchstens ca. 90 ppbw Bor, höchstens ca. 90 ppbw Phosphor, höchstens ca. 8 ppbw Arsen verwendet. Im Reinraum wurden ausschließlich Reinraumfilter mit einer PTFE-Membran verwendet (Borfreie PTFE-Filter).

Das auf Bruchgröße 0 und 1 zerkleinerte Silicium wurde in fünf Siliciumgefäße gegeben und zu fünf FZ-Stäben verarbeitet.

Von diesen wurde je eine Scheibe abgetrennt, mit HF/HNO3-geätzt, mit 18 MOHm Wasser gespült und getrocknet. An den Scheiben wurden Photolumineszenzmessungen durchgeführt.

Von den ermittelten Werten wurden die bekannten Bulkkonzentrationen für Bor und Phosphor abgezogen.

**Tabelle 2** zeigt die sich ergebenden Werte für Bor und Phosphor in ppta.

Es zeigt sich zunächst eine gute Übereinstimmung der Ergebnisse der beiden Messmethoden.

Weiterhin zeigt sich, dass durch die Zerkleinerung des Stabes mittels des Brechers das Niveau an Verunreinigungen mit Oberflächendotierstoffen gegenüber der Vorzerkleinerung mit dem Hammer nicht ansteigt.

Dies belegt, dass die mechanische Bearbeitung, also Bearbeitung mit Hammer oder Zerkleinerung im Brecher, an sich keinen wesentlichen Einfluss auf den Gehalt an Oberflächendotierstoffen hat.

Dies ist in Übereinstimmung mit den in Tabelle 1 dargestellten Ergebnissen. Auch hier zeigen sich keine wesentlichen Veränderungen bei den Stäben, die zusätzlich durch den Brecher geführt worden waren.

Wesentlich beeinflusst wird die Oberflächenreinheit in Bezug auf Dotierstoffe durch die Verkleidung der Metallteile, die Reinraumbedingungen und das Handling.

Die Messmethode über einen Bruderstab als Referenz wird im Rahmen der Erfindung bevorzugt.

**Tabelle 2**

| | B in ppta | P in ppta |
|---|---|---|
| #1 | 20 | 6 |
| #2 | 29 | 16 |
| #3 | 31 | 22 |
| #4 | 37 | 17 |
| #5 | 12 | 9 |

### Beispiel 2 - Erzeugung eines dotierstoffarmen gereinigten Polybruchs

Ein Polysiliciumstab wurde zerkleinert (Vorzerkleinerung mit Hammer und Zerkleinerung mittels Brecher auf Bruchgröße 4).

Dabei kamen Stahlwerkzeuge zum Einsatz. In diesem Zusammenhang wird in vollem Umfang auf US2010/0001106 A1 Bezug genommen. Es ist bekannt, dass sich dabei entstehende Verunreinigungen in einem nachfolgenden Reinigungsschritt leicht entfernen lassen.

5 kg Polybruch der Bruchgröße 4 wurden in einer Prozessschale in einem dreistufigen nasschemischen Prozess behandelt. Die Vorreinigung und die Hauptreinigung erfolgten in separaten Säurekreisen:
a) Vorreinigung in Beize
   20 Min Reinigen in einer Mischung aus 5 Gew.-% HF, 8 Gew.-% HCl, 3 Gew.-% H₂O₂ bei einer Temperatur von 22 °C Materialabtrag: 0,02 µm
b) Spülen mit Reinstwasser 18 MOHM für 5 Minuten bei 22 °C
c) Hauptreinigung: Ätzen 5 Min bei 8 °C
   HF/HNO₃ mit 6 Gew.-% HF, 55 Gew.-% HNO₃ und 1 Gew.-% Si Ätzabtrag: ca. 30 µm
d) 5 Min Spülen mit 22 °C warmem Reinstwasser mit 18 MOHM
e) 5 Min Hydrophilierung in 22 °C warmem Wasser, das mit 20 ppm Ozon gesättigt ist
f) 60 Min Trocknen mit Reinstluft der Klasse 100 bei 80 °C mit Borfreiem PTFE-Filter (Aufbau und Zusammensetzung wie unter b) Zerkleinern des polykristallinen Siliciums beschrieben)
g) Abkühlen mit Reinstluft 22 °C mit PTFE-Filter (Aufbau und Zusammensetzung wie unter b) Zerkleinern des polykristallinen Siliciums beschrieben)
h) Händisches Verpacken des Polysiliciums mittels PE- Handschuh in einen hochreinen PE-Beutel

Alle verwendeten Kunststoffe hatten jeweils einen Bor-, Phosphor- und Arsengehalt kleiner 10 ppbw.

Die verwendeten Mineralsäuren HCl, HF und Salpetersäure enthielten maximal 10 ppbw Bor, 500 ppbw Phosphor und 50 ppbw Arsen.

Weiterhin wurden 27 polykristalline Siliciumstäbe, jeweils 10 bis 20 cm lang und mit einem Durchmesser von jeweils 1,6 cm, analog **Beispiel 1** den Bedingungen der Vorzerkleinerung und der Bearbeitung mit einem Brecher ausgesetzt, wobei abweichend von **Beispiel 1** Stahlwerkzeuge gemäß US2010/0001106 A1 zum Einsatz kamen. Die Stäbe wurden jeweils auf einem Arbeitstisch abgelegt, während auf diesem ein Stab mittels eines Hammers zerkleinert wurde. Zudem wurden die Stäbe durch den Brecher geführt, ohne eine Zerkleinerung vorzunehmen.

Anschließend wurden diese Stäbe der Behandlung gemäß Schritten a) bis g) unterzogen.

Schließlich wurden die Stäbe jeweils mittels eines PE-Handschuhs in einen hochreinen PE-Beutel verpackt.

Diese Stäbe wurden auf Verunreinigungen mit Dotierstoffen untersucht. Als Referenz diente wiederum jeweils ein unbehandelter Bruderstab aus derselben Abscheidecharge. Je zwei Filamentstäbe waren während der Abscheidung über eine waagrechte Brücke gekoppelt und bildeten einen Trägerkörper für die Siliciumabscheidung. Nach Abscheidung ergaben sich nach Abtrennung der Brücke jeweils zwei Stäbe: Stab und Bruderstab.

Es konnte gezeigt werden, dass die Reinigung gemäß Schritten a) bis h) und das Verpacken nach Schritt h) zu gegenüber Beispiel 1 noch besseren Werten für Oberflächenverunreinigungen mit Dotierstoffen führt. Vorzerkleinerung und Brechen fanden unter denselben Bedingungen statt.

**Tabelle 3** zeigt die für **Beispiel 2** bestimmten Oberflächenverunreinigungen mit Bor, Phosphor, Aluminium und Arsen.

Die Werte ergeben sich jeweils durch Differenzbildung: Verunreinigungen (Behandelter Stab) minus Verunreinigungen (Unbehandelter Referenzstab = Bruderstab).

Die Werte konnten auch durch Messung mittels FZ-Hülsenziehen an Bruchstücken der Größe 0 und 1 (erzeugt durch Vorzerkleinern eines Stabs und Brechen auf Größe 0 und 1 jeweils mit Stahlwerkzeugen) und entsprechender Behandlung gemäß Schritten a) bis g) reproduziert werden.

**Tabelle 3**

| | B in ppta | P in ppta | Al in ppta | As in ppta |
|---|---|---|---|---|
| #1 | 14 | 1 | < 0,1 | 4 |
| #2 | 19 | 5 | < 0,1 | 2 |
| #3 | 25 | 4 | 3 | 5 |
| #4 | 18 | 8 | 1 | < 0,1 |
| #5 | 27 | 1 | 1 | 4 |
| #6 | 18 | 7 | < 0,1 | 0,2 |
| #7 | 4 | 4 | 0,9 | < 0,1 |
| #8 | 4 | 10 | 4 | 7 |
| #9 | 16 | 9 | 2 | 3 |
| #10 | 8 | 9 | < 0,1 | < 0,1 |
| #11 | 7 | 20 | 1 | 3 |
| #12 | 19 | 4 | 0,8 | 4 |
| #13 | 16 | 9 | < 0,1 | 2 |
| #14 | 9 | 17 | < 0,1 | 4 |
| #15 | 2 | < 1 | 0,6 | < 0,1 |
| #16 | 3 | 21 | 1 | 2 |
| #17 | 2 | 2 | 1 | 2 |
| #18 | 3 | 16 | 6 | 4 |
| #19 | 6 | 11 | < 0,1 | 1 |
| #20 | 7 | < 1 | 1 | < 0,1 |
| #21 | 6 | < 1 | < 0,2 | 1 |
| #22 | 8 | 12 | < 0,1 | 4 |
| #23 | 5 | 13 | 7 | 4 |
| #24 | 5 | 5 | < 1 | 5 |
| #25 | 8 | < 1 | < 0,1 | 1 |
| #26 | 10 | < 1 | 5 | 4 |
| #27 | 9 | 2 | 1 | 1 |

### Beispiel 3 (Vergleichsbeispiel)

Ein Polysiliciumstab wurde analog **Beispiel 2** auch zu Bruchgröße 4 zerkleinert.

5 kg Polybruch der Bruchgröße 4 wurden dann abweichend von **Beispiel 2** in einer Prozessschale nasschemisch behandelt. Die Vorreinigung und die Hauptreinigung erfolgten in separaten Säurekreisen:
a) Vorreinigung in Beize
   20 Min Reinigen in einer Mischung aus 5 Gew.-% HF, 8 Gew.-% HCl, 3 Gew.-% H₂O₂ bei einer Temperatur von 22 °C; Materialabtrag: 0,02 µm
b) Spülen mit Reinstwasser 18 MOHM (5 Minuten, 22 °C)
c) Hauptreinigung: Ätzen 5 Min bei 8 °C mit HF/HNO₃ mit 6 Gew.- % HF, 55 Gew.-% HNO₃ und 1 Gew.-% Si; Ätzabtrag: ca. 30 µm
d) 5 Min Spülen mit 22 °C warmem Reinstwasser mit 18 MOHM
e) 5 Min Hydrophilierung in 22 °C warmem Wasser, das mit 20 ppm Ozon gesättigt ist
f) 60 Min Trocknen mit Reinstluft Klasse 100 bei 80 Grad mit einer borhaltigen Glasfaser mit 11 Gew. % B₂O₃
g) Abkühlen mit Reinstluft 22 °C mit einem Reinraumfilter mit einer borhaltigen Glasfaser mit 11 Gew.-% B₂O₃
h) Händisches Verpacken mit einem handelsüblichen Baumwollpolyesterhandschuh (Borgehalt > 50 pptw, P > 50 pptw und As > 10 pptw).

Ätzbecken und Rohrleitungen waren dabei nicht mit speziellen Kunststoffen ummantelt.

Die verwendeten Mineralsäuren HCl, HF und Salpetersäure waren von technischer Qualität (B > 10 ppbw, P > 500 ppbw, As > 50 ppbw).

Derselben Behandlung gemäß Schritten a) bis h) wurden auch vierzehn 10 bis 20 cm lange polykristalline Stäbe, jeweils mit einem Durchmesser von 1,6 cm unterzogen. Diese waren zuvor wie in **Beispiel 2** den Bedingungen der Vorzerkleinerung mit Hammer und des Brechers ausgesetzt worden.

Diese Stäbe wurden auf Verunreinigungen mit Bor und Phosphor untersucht. Als Referenz diente wiederum jeweils ein unbehandelter Bruderstab aus derselben Abscheidecharge. Je zwei Filamentstäbe waren während der Abscheidung über eine waagrechte Brücke gekoppelt und bildeten einen Trägerkörper für die Siliciumabscheidung. Nach Abscheidung ergaben sich nach Abtrennung der Brücke jeweils zwei Stäbe: Stab und Bruderstab.

**Tabelle 4** zeigt die für **Beispiel 3** bestimmten Oberflächenverunreinigungen von B und P.

Die Werte ergeben sich jeweils durch Differenzbildung: Verunreinigungen (Behandelter Stab) minus Verunreinigungen (Unbehandelter Referenzstab = Bruderstab).

Es zeigen sich gegenüber **Beispiel 2** deutlich erhöhte Werte, die auch durch die Messmethode FZ-Hülsenziehen an entsprechend gemäß Schritten a) bis h) behandelten Bruchstücken der Größen 0 und 1 reproduziert werden konnte.

**Tabelle 4**

| | B in ppta | P in ppta |
|---|---|---|
| #1 | 73 | 106 |
| #2 | 112 | 70 |
| #3 | 177 | 54 |
| #4 | 62 | 70 |
| #5 | 60 | 59 |
| #6 | 61 | 67 |
| #7 | 74 | 105 |
| #8 | 119 | 405 |
| #9 | 138 | 332 |
| #10 | 56 | 76 |
| #11 | 518 | 304 |
| #12 | 71 | 65 |
| #13 | 128 | 250 |
| #14 | 106 | 225 |

## Patentansprüche

1. Polykristallines Siliciumbruchstück mit einer Konzentration von 1-50 ppta Bor und 1-50 ppta Phosphor an der Oberfläche.

2. Polykristallines Siliciumbruchstück nach Anspruch 1, mit einer Konzentration von Bor an der Oberfläche von 1-30 ppta.

3. Polykristallines Siliciumbruchstück nach Anspruch 1 oder nach Anspruch 2, mit einer Konzentration von Phosphor an der Oberfläche 1-25 ppta.

4. Polykristallines Siliciumbruchstück nach einem der Ansprüche 1 bis 3, mit einer Konzentration von Arsen von 0,01-10 ppta an der Oberfläche.

5. Polykristallines Siliciumbruchstück nach einem der Ansprüche 1 bis 4, mit einer Konzentration von Aluminium von 0,01-10 ppta an der Oberfläche.

6. Polykristallines Siliciumbruchstück nach einem der Ansprüche 1 bis 5, wobei eine Konzentration an Metallen an der Oberfläche 10-200 pptw beträgt.

7. Polykristallines Siliciumbruchstück nach einem der Ansprüche 1 bis 6, wobei an dessen Oberfläche die Konzentration von Fe 1-40 pptw, von Cr 0,1-5 pptw, von Cu 0,1-5 pptw, von Na 1-30 pptw, von Ni 0,1-5 pptw, von Ca 0,1-10 pptw, von Ti 0,1-10 pptw, von W 0,1-10 pptw und von Zn 0,1-10 pptw beträgt.

8. Polykristallines Siliciumbruchstück nach Anspruch 7, wobei die Konzentration von Fe an der Oberfläche 1-20 pptw beträgt.

9. Polykristallines Siliciumbruchstück nach einem der Ansprüche 1 bis 8, wobei Dotierstoffe im Bulk in folgenden Konzentrationen vorliegen: Phosphor 1-20 ppta, Bor 1-10 ppta und Arsen 1-10 ppta.

10. Polykristallines Siliciumbruchstück nach Anspruch 9, wobei Dotierstoffe im Bulk in folgenden Konzentrationen vorliegen: Phosphor 1-10 ppta, Bor 1-5 ppta und Arsen 1-5 ppta.

## Claims

1. Polycrystalline silicon chunk having a concentration of 1-50 ppta of boron and 1-50 ppta of phosphorus at the surface.

2. Polycrystalline silicon chunk according to Claim 1, having a concentration of boron at the surface of 1-30 ppta.

3. Polycrystalline silicon chunk according to Claim 1 or according to Claim 2, having a concentration of phosphorus at the surface of 1-25 ppta.

4. Polycrystalline silicon chunk according to any of Claims 1 to 3, having a concentration of arsenic of 0.01-10 ppta at the surface.

5. Polycrystalline silicon chunk according to any of Claims 1 to 4, having a concentration of aluminum of 0.01-10 ppta at the surface.

6. Polycrystalline silicon chunk according to any of Claims 1 to 5, having a concentration of metals at the surface of 10-200 pptw.

7. Polycrystalline silicon chunk according to any of Claims 1 to 6, wherein the concentration of Fe at the surface thereof is 1-40 pptw, that of Cr 0.1-5 pptw, that of Cu 0.1-5 pptw, that of Na 1-30 pptw, that of Ni 0.1-5 pptw, that of Ca 0.1-10 pptw, that of Ti 0.1-10 pptw, that of W 0.1-10 pptw and that of Zn 0.1-10 pptw.

8. Polycrystalline silicon chunk according to Claim 7, wherein the concentration of Fe at the surface is 1-20 pptw.

9. Polycrystalline silicon chunk according to any of Claims 1 to 8, wherein dopants are present in the bulk in the following concentrations: phosphorus 1-20 ppta, boron 1-10 ppta and arsenic 1-10 ppta.

10. Polycrystalline silicon chunk according to Claim 9, wherein dopants are present in the bulk in the following concentrations: phosphorus 1-10 ppta, boron 1-5 ppta and arsenic 1-5 ppta.

## Revendications

1. Fragment de silicium polycristallin présentant une concentration en bore de 1-50 ppt en atome et en phosphore de 1-50 ppt en atome à la surface.

2. Fragment de silicium polycristallin selon la revendication 1, présentant une concentration en bore à la surface de 1-30 ppt en atome.

3. Fragment de silicium polycristallin selon la revendication 1 ou 2, présentant une concentration en phosphore à la surface de 1-25 ppt en atome.

4. Fragment de silicium polycristallin selon l'une quelconque des revendications 1 à 3, présentant une concentration en arsenic à la surface de 0,01-10 ppt en atome.

5. Fragment de silicium polycristallin selon l'une quelconque des revendications 1 à 4, présentant une concentration en aluminium à la surface de 0,01-10 ppt en atome.

6. Fragment de silicium polycristallin selon l'une quelconque des revendications 1 à 5, la concentration en métaux à la surface étant de 10-200 ppt en poids.

7. Fragment de silicium polycristallin selon l'une quelconque des revendications 1 à 6, la concentration, à sa surface, en Fe étant de 1-40 ppt en poids, en Cr étant de 0,1-5 ppt en poids, en Cu étant de 0,1-5 ppt en poids, en Na étant de 1-30 ppt en poids, en Ni étant de 0,1-5 ppt en poids, en Ca étant de 0,1-10 ppt en poids, en Ti étant de 0,1-10 ppt en poids, en W étant de 0,1-10 ppt en poids et en Zn étant de 0,1-10 ppt en poids.

8. Fragment de silicium polycristallin selon la revendication 7, la concentration en Fe à la surface étant de 1-20 ppt en poids.

9. Fragment de silicium polycristallin selon l'une quelconque des revendications 1 à 8, les substances de dopage se trouvant aux concentrations suivantes dans la masse : phosphore 1-20 ppt en atome, bore 1-10 ppt en atome et arsenic 1-10 ppt en atome.

10. Fragment de silicium polycristallin selon la revendication 9, les substances de dopage se trouvant à la concentration suivantes dans la masse : phosphore 1-10 ppt en atome, bore 1-5 ppt en atome et arsenic 1-5 ppt en atome.
